(19) Europäisches Patentamt
European Patent Office
Office européen des brevets

(11) **EP 2 856 191 B1**

(12) **EUROPÄISCHE PATENTSCHRIFT**

(45) Veröffentlichungstag und Bekanntmachung des Hinweises auf die Patenterteilung:
**12.10.2016 Patentblatt 2016/41**

(21) Anmeldenummer: **13726473.5**

(22) Anmeldetag: **24.05.2013**

(51) Int Cl.:
**B60L 11/18** (2006.01)    **G01R 31/36** (2006.01)

(86) Internationale Anmeldenummer:
**PCT/EP2013/060725**

(87) Internationale Veröffentlichungsnummer:
**WO 2013/174972 (28.11.2013 Gazette 2013/48)**

(54) **VERFAHREN UND EINE VORRICHTUNG ZUR PRÜFUNG VON ELEKTRISCHEN ENERGIESPEICHERSYSTEMEN FÜR DEN ANTRIEB VON FAHRZEUGEN**

METHOD AND DEVICE FOR TESTING ELECTRIC ENERGY STORAGE SYSTEMS FOR VEHICLE PROPULSION

PROCÉDÉ ET DISPOSITIF PERMETTANT DE CONTRÔLER DES SYSTÈMES D'ACCUMULATEURS D'ÉNERGIE ÉLECTRIQUE POUR LA PROPULSION DE VÉHICULES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.05.2012 AT 502012012**

(43) Veröffentlichungstag der Anmeldung:
**08.04.2015 Patentblatt 2015/15**

(73) Patentinhaber: **AVL List GmbH**
**8020 Graz (AT)**

(72) Erfinder:
 • **KÖNIG, Oliver**
  **8042 Graz (AT)**
 • **JAKUBEK, Stefan**
  **1230 Wien (AT)**
 • **PROCHART, Günter**
  **8042 Graz (AT)**
 • **GSCHWEITL, Kurt**
  **8063 Eggersdorf (AT)**

(74) Vertreter: **Patentanwälte Pinter & Weiss OG**
**Prinz-Eugen-Straße 70**
**1040 Wien (AT)**

(56) Entgegenhaltungen:
**US-A1- 2003 204 328     US-A1- 2006 284 617**
**US-A1- 2007 236 181     US-B2- 6 577 107**

 • **BATALLER-PLANES E ET AL: "Power Balance of a Hybrid Power Source in a Power Plant for a Small Propulsion Aircraft", IEEE TRANSACTIONS ON POWER ELECTRONICS, IEEE SERVICE CENTER, PISCATAWAY, NJ, US, Bd. 24, Nr. 12, 1. Dezember 2009 (2009-12-01), Seiten 2856-2866, XP011282301, ISSN: 0885-8993, DOI: 10.1109/TPEL.2009.2022943**

**Beschreibung**

Die Erfindung betrifft ein Verfahren und eine Vorrichtung, zur Prüfung von elektrischen Energiespeichersystemen, für den Antrieb von Fahrzeugen, bei dem der Laststrom des Energiespeichersystems von einem Batterietester erzeugt wird und mittels eines Regelkreises mit einem Modell des Batterietesters als Regelstrecke einem gemäß vorgegebenen Testzyklen zeitlich veränderlichen Referenzstrom möglichst exakt und ohne Verzugszeit nachgeführt wird.

Bei der Erprobung von Hybridfahrzeugen oder auch gänzlich elektrisch betriebenen Fahrzeugen ist die Prüfung der Traktionsbatterien von besonderer Bedeutung. Die US 6 577 107 B2 zeigt eine Anordnung zum Testen einer Batterie, wobei der Batterie gemäß einer vorgegebenen Ladesequenz ein Laststrom beaufschlagt wird.

Bei der Prüfung der Batterien soll der Teststrom vorgegebenen Testzyklen mit hochdynamischen Transienten möglichst exakt und ohne Verzögerung folgen. Dies kann über einen entsprechenden Regelkreis erreicht werden, der über ein modellbasiertes Reglerentwurfsverfahren konzipiert wird. In der US2006/284617 A1 wird ein Modell einer Batterie beschrieben.

Die Stromregelung soll dabei durch den Prüfling möglichst nicht beeinflusst werden. Da jedoch die Gegenspannung des Prüflings wesentlich vom eingeprägten Strom, d.h. der Regelgröße, abhängt, hat dieser maßgeblichen Einfluss auf die dynamischen Eigenschaften des Regelkreises. Um diesen Einfluss zu vermindern, gibt es mehrere Möglichkeiten. Einerseits kann eine Auslegung der Leistungselektronik mit möglichst großer Ausgangsimpedanz erfolgen. Dies führt jedoch zu einer Reduktion der erreichbaren Regelbandbreite und hat erhöhte Materialkosten sowie erhöhten Platzbedarf zur Folge, weil dafür größere Induktivitäten notwendig sind. Bei der Methode der Störgrößenaufschaltung wird die gemessene Gegenspannung des Prüflings als Störgröße aufgefasst und zur Kompensation der Störung herangezogen. Es wird allerdings davon ausgegangen, dass die Störgröße von der Regelgröße unabhängig ist. Tatsächlich ist aber die Klemmenspannung einer Batterie auf Grund der endlichen Batterieimpedanz vom eingeprägten Strom abhängig. Das Verhalten der Störgröße als Reaktion auf Änderungen des eingeprägten Stroms kann somit nicht vorausschauend kompensiert werden.

Die Aufgabe der vorliegenden Erfindung war daher eine Verbesserung des Verfahrens und der Vorrichtung wie eingangs angegeben in einer Weise, dass die Last keine unbekannte Störung mehr darstellt, sondern bei der Regelung explizit berücksichtigt werden kann.

Das Problem bei den bisherigen Systemen liegt darin, dass das Verhalten der Stromregelung von der Impedanz der Batterie (UUT) abhängt. Eine ungünstige Impedanz führt zu langsamerem Führungsverhalten und starkem Überschwingen des Teststroms. Die Impedanz ändert sich zudem mit dem Alter und dem Ladezustand der Batterie und hängt vom Arbeitspunkt (Laststrom) ab.

Die Aufgabe der vorliegenden Erfindung waren daher ein verbessertes Verfahren und eine verbesserte Vorrichtung, mit welchen im Zuge der Stromregelung im Batterietester der tatsächliche Laststrom möglichst exakt und ohne Verzugszeit einem zeitlich veränderlichen Referenzstrom nachgeführt werden kann, um die gewünschten Testzyklen durchzuführen.

Zur Lösung dieser Aufgabenstellung ist das Verfahren erfindungsgemäß dadurch gekennzeichnet, dass der Regelkreis mittels eines modellbasierten Reglerentwurfsverfahrens erstellt wird, bei welchem in das Modell der Regelstrecke ein Modell des Energiespeichersystems als Last eingebunden wird. Die Gegenspannung der Batterie stellt für die Stromregelung prinzipiell eine Störung dar. Das Modell der Batterieimpedanz ermöglicht eine annähernde Vorhersage des Verlaufs dieser Störgröße als Reaktion auf den eingeprägten Strom. Dadurch kann eine schnellere und robustere Reaktion des tatsächlichen Stroms auf Veränderungen des Referenzstroms erreicht werden.

Gemäß einer vorteilhaften Variante des Verfahrens ist vorgesehen, dass die Parameter für ein generisches Modell der Batterieimpedanz durch zumindest eine kurze Anregungssequenz und Messung der resultierenden Werte von Strom und Spannung identifiziert werden.

Die Vorrichtung zur Prüfung von elektrischen Energiespeichersystemen für den Antrieb von Fahrzeugen, mit einem Regelkreis zur Nachführung des Laststromes des Energiespeichersystems gemäß vorgegebenen Testzyklen nach einem zeitlich veränderlichen Referenzstrom möglichst ohne Verzugszeit, ist zur Lösung der gestellten Aufgabe dadurch gekennzeichnet, dass im Regelkreis eine modellbasierte Regelung realisiert und in dessen Modell ein Modell der Batterieimpedanz eingebunden ist.

Eine vorteilhafte Ausführungsform der Erfindung ist dadurch gekennzeichnet, dass ein vom Arbeitspunkt der Batterie abhängiges Modell der Batterieimpedanz eingebunden ist.

Dabei kann alternativ auch ein vom Ladezustand der Batterie abhängiges Modell der Batterieimpedanz eingebunden sein.

Als weitere Alternative könnte eine erfindungsgemäße Vorrichtung dadurch gekennzeichnet sein, dass ein vom Alter der Batterie abhängiges Modell der Batterieimpedanz eingebunden ist.

Für alle der genannten Varianten ist eine vorteilhafte Ausführungsform dadurch gekennzeichnet, dass im Regelkreis eine modellbasierte prädiktive Regelung realisiert ist. Die Einbindung ist prinzipiell mit jedem modellbasierten Reglerentwurfsverfahren möglich. Die modellbasierte prädiktive Regelung (MPC) ermöglicht es zudem, physikalische Beschränkungen (z.B. Stellgrößenbeschränkungen oder Strombegrenzungen zum Schutz der Halbleiterschalter im Batteriesimulator) bei der Optimierung des Stellgrößenverlaufs explizit zu berücksichtigen.

Vorzugsweise ist das Modell der Batterieimpedanz als Übertragungsfunktion 2. oder höherer Ordnung dargestellt.

In der nachfolgenden Beschreibung soll die Erfindung näher erläutert werden.

In den beigefügten Zeichnungsfiguren zeigt die Fig. 1 eine schematische Darstellung eines Batterietesters, Fig. 2 ist ein Blockdiagramm für die Vorgehensweise beim Entwurf eines Stromreglers mit integriertem Lastmodell, Fig. 3 zeigt ein Blockschaltbild der Regelstrecke, die Fig. 4 stellt ein Blockschaltbild der Regelstrecke mit inkludiertem Lastmodell dar, Fig. 5 zeigt ein Schaltbild der Leistungselektronik, Fig. 6 zeigt eine Systemantwort des erfindungsgemäßen Systems auf eine Anregungssequenz, mit Darstellung der vorgegebenen Anregungssequenz und der daraus resultierenden Messwerte für Strom und Spannung bei Betrieb mit dem vorläufigen Regler ohne Lastmodell, Fig. 7 zeigt ein Diagramm für die simulierte Systemantwort mit nicht optimierten Parametern im Vergleich zur aufgezeichneten Systemantwort, die Fig. 8 ist eine Darstellung der simulierten Systemantwort mit optimierten Parametern im Vergleich zur aufgezeichneten Systemantwort, und Fig. 9 schließlich zeigt einen Vergleich der Systemantworten auf einen Führungsgrößensprung von 40 A auf 80 A bei Stromregelung mit und ohne Lastmodell.

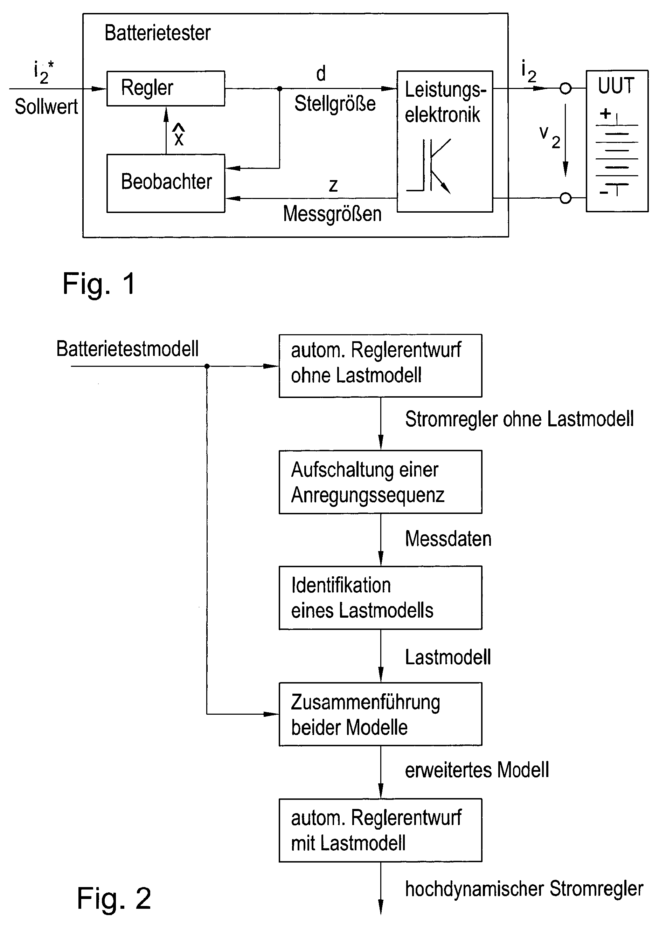

Ein in Fig. 1 beispielhaft dargestelltes System besteht aus dem Prüfling, d.h. der Traktions-batterie, und dem Batterietester. Der Batterietester wiederum besteht aus Leis-tungselektronik und vorzugsweise digitalem Regler. Die Klemmenspannung der Batterie ist hier mit $v_2$, der einzuprägende Laststrom mit $i_2$ und die Stromreferenz mit $i_2^*$ gekennzeichnet. Die Leistungselektronik wird über die Vorgabe eines pulsweitenmodulierten Signals (PWM) mit dem Duty Cycle $d$ angesteuert. Die gemessenen Größen sind im Messgrößenvektor $d$ zusammengefasst. Der Regler ist vorzugsweise als modellprädiktiver Regler (MPC) mit Berücksichtigung von Stellgrößenbeschränkungen ausgeführt. Ein Zustandsbeobachter verarbeitet die Messdaten sowie die zuletzt ausgegebene Stellgröße und schätzt daraus den Zustandsvektor, der vom Regler benötigt wird.

Modellprädiktive Reglerentwurfsverfahren wurden gewählt, weil damit der Entwurf basierend auf einem Modell der Regelstrecke automatisierbar ist und weil damit die inhärente Stellgrößenbeschränkung der Leistungselektronik (der Duty Cycle ist nur im Bereich von $0 \leq d \leq 1$ veränderbar) berücksichtigt werden kann.

Mit Hilfe eines Modells des Batterietesters wird ein vorläufiger Regler ohne Modell der Last entworfen. Der Batterietester wird dann bei angeschlossenem Prüfling mit dem vorläufigen Regler betrieben. Eine geeignete Anregungssequenz (bspw. eine pseudozufällige Binärsequenz (PRBS)) wird als Referenzsignal $i_2^*$ verwendet. Dabei werden der tatsächliche Laststrom $i_2$ und die Klemmenspannung $v_2$ mit der Abtastrate des Reglers aufgezeichnet. Anhand der Messdaten wird anschließend ein Modell der Last identifiziert und schließlich das Modell des Batterietesters um das Modell der Last erweitert. Mit dem erweiterten Modell des gesamten Systems wird erneut ein Regler entworfen, der dann dazu verwendet werden kann, um den Prüfling mit hochdynamischen Testsequenzen zu beaufschlagen. Dieser Ablauf ist in Fig. 2 zusammenfassend dargestellt.

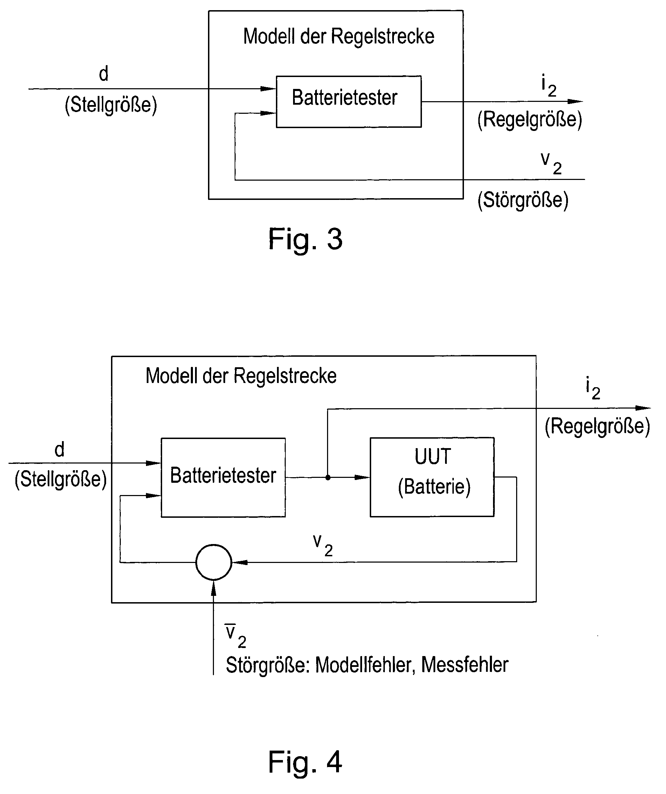

Für den oben erwähnten Reglerentwurf ist ein Modell der Regelstrecke notwendig. In Fig. 3 ist die Regelstrecke ohne Berücksichtigung der Last als Blockschaltbild dargestellt. Der Duty Cycle d fungiert dabei als Stellgröße, der Laststrom $i_2$ ist die Regelgröße und Klemmenspannung $v_2$ der Batterie wird als Störgröße interpretiert. Der zukünftige Verlauf dieser Störgröße ist nicht bekannt, d.h. der Regler kann erst reagieren, wenn sich die Störgröße bereits verändert hat.

Wenn ein Modell der Batterie vorhanden ist, kann dieses in das Modell der Regelstrecke integriert werden. Das resultierende Blockschaltbild ist in Fig. 4 dargestellt. Die Klemmenspannung wird dadurch nicht mehr als Störgröße sondern als neue Zustandsgröße des erweiterten Systems betrachtet. Damit können zumindest jene zukünftigen Änderungen der Klemmenspannung abgeschätzt werden, die von Änderungen des eingeprägten Teststroms verursacht werden - unter der Voraussetzung, dass das Lastmodell hinreichend genau ist. Messfehler und Fehler im Lastmodell werden nach wie vor als Störgröße betrachtet. Folglich werden zwei getrennte Modelle, eines von der Last und eines vom Batterietester benötigt.

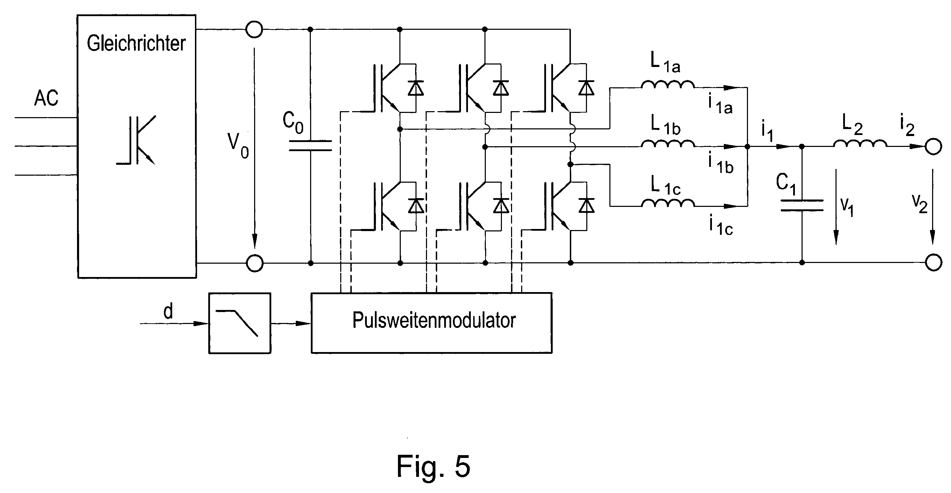

Der verwendete Batterietester besteht aus einem geregelten Tiefsetzsteller mit drei versetzt schaltenden IGBT-Halbbrücken. Ein vereinfachtes Schaltbild der Ausgangsstufe mit den relevanten Komponenten ist in Fig. 5 dargestellt.

Die Dynamik des Systems wird vom passiven Ausgangsfilter bestimmt. Dieses besteht aus den drei Speicherdrosseln $L_{1a}$, $L_{1b}$ und $L_{1c}$, dem Filterkondensator $C_1$ und der Siebdrossel $L_2$. Wenn alle drei Speicherdrosseln die gleiche Induktivität aufweisen $L_{1a} = L_{1b} = L_{1c}$, so kann des dynamische Verhalten der Ausgangsstufe mit einem Modell eines einphasigen Tiefsetzstellers bestehend aus nur einer Halbbrücke und einer Speicherdrossel $L_1 = 1/3L_{1a} = 1/3L_{1b} = 1/3L_{1c}$ approximiert werden.

Für das einphasige Ausgangsfilter kann nun ein zeitkontinuierliches Zustandsraummodell aufgestellt werden, mit dem Zustandsvektor $\dot{x}_c = [i_1\ v_1\ i_2]^\mathrm{T}$:

$$\dot{\boldsymbol{x}}_{\mathrm{c}} = \underbrace{\begin{bmatrix} -\frac{R_{L1}}{L_1} & -\frac{1}{L_1} & 0 \\ \frac{1}{C_1} & 0 & -\frac{1}{C_1} \\ 0 & \frac{1}{L_2} & -\frac{R_{L2}}{L_2} \end{bmatrix}}_{\boldsymbol{A}_{\mathrm{c}}} \boldsymbol{x}_{\mathrm{c}} + \underbrace{\begin{bmatrix} \frac{1}{L_1} \\ 0 \\ 0 \end{bmatrix}}_{\boldsymbol{B}_{\mathrm{c}}} dV_0 + \underbrace{\begin{bmatrix} 0 \\ 0 \\ -\frac{1}{L_2} \end{bmatrix}}_{\boldsymbol{E}_{\mathrm{c}}} v_2$$

$$i_2 = \underbrace{\begin{bmatrix} 0 & 0 & 1 \end{bmatrix}}_{\boldsymbol{C}_{\mathrm{c}}} \boldsymbol{x}_{\mathrm{c}}. \tag{1}$$

Der Duty Cycle $d$ und die Klemmenspannung $v_2$ sind die Modelleingänge (als Stellgröße bzw. Störgröße). Die Größen $i_1$, $i_2$ und $v_2$ stehen dem Regler als Messgrößen zur Verfügung. Wenn die Kondensatorspannung $v_1$ nicht gemessen wird, ist ein Zustandsbeobachter notwendig, um den aktuellen Zustandsvektor laufend zu rekonstruieren.

Für den zeitdiskreten, digitalen Regler ist ein entsprechendes zeitdiskretes Modell des Batterietesters notwendig. Dafür wird die PWM durch ein Abtast-Halteglied (zero-order hold, ZOH) approximiert. Das resultierende Modell kann mit der Übergangsmatrix $\boldsymbol{A}_{\mathrm{d}}$, der Eingangsmatrix $\boldsymbol{B}_{\mathrm{d}}$, der Störeingangsmatrix $\boldsymbol{E}_{\mathrm{d}}$ und der Ausgangsmatrix $\boldsymbol{C}_{\mathrm{d}}$ als Zustandsraummmodell dargestellt werden:

$$\boldsymbol{x}_{\mathrm{c}k+1} = \boldsymbol{A}_{\mathrm{d}} \cdot \boldsymbol{x}_{\mathrm{c}k} + \boldsymbol{B}_{\mathrm{d}} \cdot \mathrm{d}_k V_0 + \boldsymbol{E}_{\mathrm{d}} \cdot v_{2k}, \quad i_{2k} = \boldsymbol{C}_{\mathrm{d}} \cdot \boldsymbol{x}_{\mathrm{c}k} \tag{2}$$

Der Index $k$ bezeichnet jeweils den aktuellen Zeitschritt.

Die Konvertierung in das zeitdiskrete Modell erfolgt über standardmäßige Schritte, beispielsweise mit dem Matlab-Befehl c2d.m. Auf Grund der benötigten Berechnungszeit des Reglers kann der berechnete neue Wert der Stellgröße nicht sofort, sondern immer erst zum nächsten Abtastzeitpunkt angewendet werden. Dieser Umstand wird berücksichtigt, indem das Zustandsraummodel um eine zusätzliche Verzögerung von einer Abtastperiode erweitert wird. Das damit erhaltene Modell des Batterietesters ist von der angeschlossenen Last unab-hängig, muss deshalb für jeden Batterietester nur einmal aufgestellt werden und bleibt an-schließend unverändert.

Batterien weisen grundsätzlich ein sehr komplexes dynamisches Verhalten auf, das von vielen Faktoren - insbesondere vom Ladezustand, den Zelltemperaturen und vom Lade- bzw. Entladestrom - abhängt. Dementsprechend komplexe Modelle sind notwendig, um dieses Verhalten nachbilden bzw. vorhersagen zu können.

Die elektrischen und elektrochemischen Effekte, die für das dynamische Verhalten einer Batterie verantwortlich sind, weisen unterschiedliche Zeitkonstanten auf. Für die Regelung des Batterietesters sind die Effekte mit kleinen Zeitkonstanten wichtig. Das sind im Speziellen die Zuleitungs- und Kontaktwiderstände, die Induktivitäten der Zuleitungen und Kontaktierungen sowie kapazitive Effekte. Effekte mit großen Zeitkonstanten stellen langsam veränderliche Störgrößen dar, die von einem schnellen Regler gut kompensiert werden können.

Aus diesem Grund ist für die Regelung des Teststroms ein stark vereinfachtes Modell ausreichend, in dem nur die schnellen Effekte abgebildet werden. Außerdem hat die Ordnung des eingebetteten Lastmodells einen Einfluss auf den Rechenaufwand, der für die Regelung zur Laufzeit betrieben werden muss. Folglich ist die verwertbare Modellordnung durch die zur Verfügung stehende Rechenleistung und die Abtastrate stark beschränkt.

Für die beschriebenen Versuche wurde ein Modell der Ordnung 2 gewählt, das als allgemeine zeitdiskrete Übertragungsfunktion $Z(z)$ mit dem z-transformierten Teststrom $I_2(z)$ als Eingang und der z-transformierten Klemmen-spannung $V_2(z)$ als Ausgang angesetzt wird:

$$Z(z) = \frac{V_2(z)}{I_2(z)} = \frac{b_0 + b_1 z^{-1} + b_2 z^{-2}}{1 + a_1 z^{-1} + a_2 z^{-2}} \tag{3}$$

Die freien Parameter der Übertragungsfunktion werden in den Parametervektoren $\theta_a = [a_1, a_2]$ und $\theta_b = [b_0\ b_1\ b_2]$ zusammengefasst.

Diese Übertragungsfunktion kann mit der Regelungsnormalform in eine äquivalente Zustandsraumdarstellung gebracht werden:

$$\boldsymbol{x}_{\mathrm{L}k+1} = \underbrace{\begin{bmatrix} 0 & 1 \\ -a_2 & -a_1 \end{bmatrix}}_{\boldsymbol{A}_{\mathrm{L}}} \cdot \boldsymbol{x}_{\mathrm{L}k} + \underbrace{\begin{bmatrix} 0 \\ 1 \end{bmatrix}}_{\boldsymbol{B}_{\mathrm{L}}} \cdot i_{2k} \tag{4}$$

$$v_{2k} = \underbrace{\begin{bmatrix} b_2 - a_2 b_0 & b_1 - a_1 b_0 \end{bmatrix}}_{\boldsymbol{C}_{\mathrm{L}}} \cdot \boldsymbol{x}_{\mathrm{L}k} + b_0 \cdot i_{2k} \tag{5}$$

Nun müssen noch die unbekannten Parameter mit Hilfe einer Identifikationsmethode bestimmt werden. Nachfolgend wird ein dafür mögliches Verfahren beispielhaft beschrieben.

Mit Hilfe eines Reglers basierend auf dem Modell des Batterietesters ohne Lastmodell wird der Prüfling mit einer Laststrom-Anregungssequenz beaufschlagt. Die währenddessen aufgezeichneten Spannungs- und Stromwerte werden in den Messdatenvektoren $\boldsymbol{i}_2$ (Eingangsdaten) und $\boldsymbol{v}_2$ (Ausgangsdaten) zusammengefasst. $N$ sei die Anzahl der Elemente der beiden Vektoren (= Länge der Anregungssequenz in Abtastschritten).

Als Ausgangsbasis wird mit dem tool ident.m aus der Matlab Identifikations-Toolbox eine grobe Schätzung von Modellparametern erzeugt. Zuerst wird von den Messdatenvektoren der jeweilige Mittelwert subtrahiert. Zusätzlich werden die Daten mit einem Tiefpass gefiltert, um hochfrequente Störeinflüsse zu beseitigen. Dann wird das tool verwendet um die Parametervektoren $\theta_a$, $\theta_b$ für ein ARX-Modell mit Nenner- und Zählergrad 2 zu schätzen.

Mit dem geschätzten Parametersatz kann anschließend die Antwort $\tilde{\boldsymbol{v}}_2$ des Modells auf den gemessenen Stromverlauf $\boldsymbol{i}_2$ simuliert und mit dem gemessenen Spannungsverlauf $\boldsymbol{v}_2$ verglichen werden. Wenn dabei ein großer Unterschied zwischen gemessenem und simuliertem Spannungsverlauf festgestellt wird, können die Parameter mittels Optimierung verbessert werden.

Ziel der Optimierung ist, die Summe der Fehlerquadrate J als Funktion von den Modellparametern $\theta_a$, $\theta_b$ zu minimieren:

$$\min J(\theta_a, \theta_b)$$

Mit $J(\theta_a,\theta_b) = \boldsymbol{e}(\theta_a,\theta_b)^{\mathsf{T}} \cdot \boldsymbol{e}(\theta_a,\theta_b)/N$ und $\boldsymbol{e}(\theta_a,\theta_b) = \boldsymbol{v}_2 - \tilde{\boldsymbol{v}}_2(\theta_a,\theta_b)$, wobei $\tilde{\boldsymbol{v}}_2(\theta_a,\theta_b)$ das jeweilige Simulationsergebnis für die Parameter $\theta_a, \theta_b$ mit dem Eingangssignal $\boldsymbol{i}_2$ ist.

Alternativ können auch andere Identifikationsverfahren verwendet werden (bspw. Output-Error Methoden (OE)), die ein Modell mit der oben beschriebenen Struktur liefern.

Die beiden bisher beschriebenen Teilmodelle müssen noch zu einem Modell der Re-gelstrecke zusammengefasst werden.

Dafür wird ein erweiterter Zustandsvektor zusammengesetzt aus den Zustandsvektoren der Teilmodelle $\boldsymbol{x}_{\mathrm{L}k} = \begin{bmatrix} \boldsymbol{x}_{\mathrm{d}k}^{\mathsf{T}} & \boldsymbol{x}_{\mathrm{L}k}^{\mathsf{T}} \end{bmatrix}^{\mathsf{T}}$ verwendet. Durch die Verbindung des Ausgangs $i_{2k} = C_{\mathrm{d}} \cdot \boldsymbol{x}_{ck}$ des Batterietestermodells mit dem Eingang $i_{2k}$ des Lastmodells und durch die Verbindung des Ausgangs $v_{2k} = C_{\mathrm{L}} \cdot \boldsymbol{x}_{\mathrm{L}k} + b_0 \cdot i_{2k}$ des Lastmodells mit dem Störeingang $v_{2k}$ des Batterietesters entsteht folgendes erweiterte Zustandsraummodell:

$$\begin{bmatrix} \boldsymbol{x}_{\mathrm{d}k+1} \\ \boldsymbol{x}_{\mathrm{L}k+1} \end{bmatrix} = \underbrace{\begin{bmatrix} \boldsymbol{A}_{\mathrm{d}} + \boldsymbol{E}_{\mathrm{d}} b_0 \boldsymbol{C}_{\mathrm{d}} & \boldsymbol{E}_{\mathrm{d}} \boldsymbol{C}_{\mathrm{L}} \\ \boldsymbol{B}_{\mathrm{L}} \boldsymbol{C}_{\mathrm{d}} & \boldsymbol{A}_{\mathrm{L}} \end{bmatrix}}_{\boldsymbol{A}} \cdot \underbrace{\begin{bmatrix} \boldsymbol{x}_{\mathrm{d}k} \\ \boldsymbol{x}_{\mathrm{L}k} \end{bmatrix}}_{\boldsymbol{x}_k} + \underbrace{\begin{bmatrix} \boldsymbol{B}_{\mathrm{d}} \\ \boldsymbol{0} \end{bmatrix}}_{\boldsymbol{B}} \cdot d_k V_0 + \underbrace{\begin{bmatrix} \boldsymbol{E}_{\mathrm{d}} \\ \boldsymbol{0} \end{bmatrix}}_{\boldsymbol{E}} \cdot \tilde{v}_{2k}$$

$$v_{2k} = \underbrace{\begin{bmatrix} \boldsymbol{C}_{\mathrm{d}} & \boldsymbol{0} \end{bmatrix}}_{\boldsymbol{C}} \cdot \begin{bmatrix} \boldsymbol{x}_{\mathrm{d}k} \\ \boldsymbol{x}_{\mathrm{L}k} \end{bmatrix} \tag{6}$$

Dieses erweiterte Modell kann auch in Matlab mit dem Befehl connect.m erzeugt werden.

Das dargestellte Modell wurde für die weiter unten beschriebenen Versuche verwendet. Es ist aber zu berücksichtigen, dass dieses Modell für den Fall $b_0 \neq 0$ nur näherungsweise gilt. Eine bessere Beschreibung des Verhaltens der erweiterten Regelstrecke könnte erreicht werden, wenn $b_0$ bereits im zeitkontinuierlichen Modell des Batterietester berücksichtigt werden würde. Wegen der Erweiterung des Zustandsvektors muss sowohl der Regler als auch der Beobachter auf das erweiterte Modell ausgelegt werden.

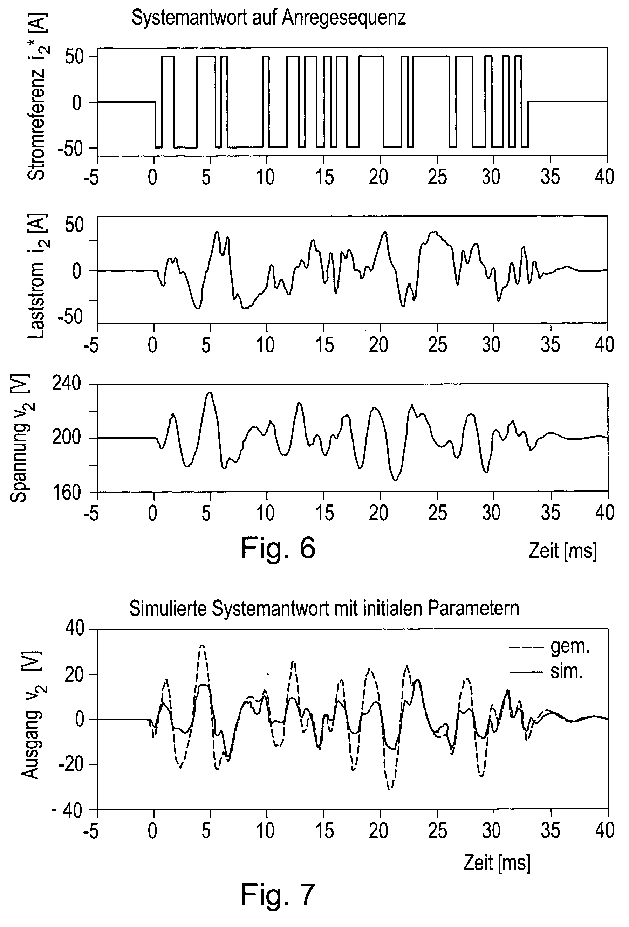

Das beschriebene Verfahren wurde an einer Versuchsanlage getestet. Für die Versu-che stand keine Traktionsbatterie als Prüfling zur Verfügung, deswegen wurde ein Batterie-simulator als Prüflast verwendet. Es ist zu beachten, dass der Batteriesimulator mit einem relativ langsamen Regler als Konstantspannungsquelle betrieben wurde. Dessen dynamisches Verhalten unterscheidet sich deutlich von dem einer Batterie. Trotzdem konnte zumindest die prinzipielle Machbarkeit gezeigt werden. Das obere Diagramm der Fig. 6 zeigt die PRB-Sequenz, das mittlere den eingeregelten Prüfstrom und das untere die daraus resultierenden Klemmenspannung.

Wie aus der Fig. 7 hervorgeht, welche die simulierte Ausgangsspannung für die Pa-rameter darstellt, die beispielsweise mit dem MatLab-Befehl ident.m bestimmt wurden, wird damit das Verhalten des Systems nur unzureichend nachgebildet. Die hier verwendeten Parameter dienten aber als Startwerte für die Optimierung der Parameter.

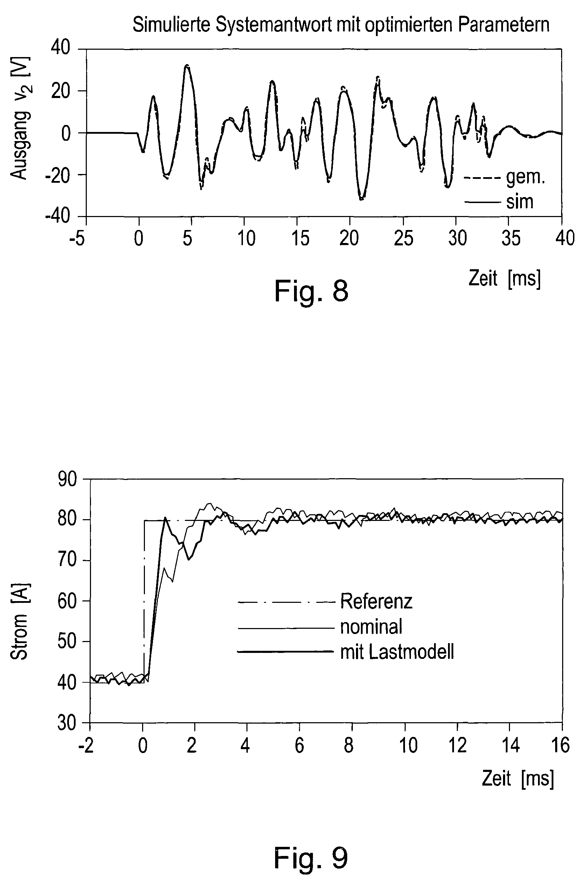

Nach Optimierung der Parameter hingegen ergibt sich die simulierte Systemantwort der Fig. 8, wobei für die simulierte Ausgangsspannung eine deutlich bessere Übereinstim-mung mit den Messdaten erreicht werden konnte. Die hier verwendeten Parameter wurden verwendet, um den Regler mit Lastmodell auszulegen.

Die Fig. 9 schließlich zeigt die gemessene Antwort des Prüfstroms auf einen Sollwertsprung bei Verwendung des Regler ohne (blau) und mit (rot) Lastmodell. Der Regler mit Lastmodell erreicht den Sollwert schneller und die Überschwingweite fällt geringer aus als beim Regler ohne Lastmodell. Allerdings tritt nach dem ersten Anstieg des Stroms ein kurzes Unterschwingen auf.

Das beschriebene Verfahren bietet die Möglichkeit einen modellprädiktiven Stromregler eines Batterietesters um ein Modell der Last zu erweitern und dadurch die Dynamik der Stromregelung für einen bestimmten Prüfling zu verbessern. Auf Grund der Verwendung eines generischen Lastmodells ist die Anwendung nicht Batterien eingeschränkt, sondern kann auch auf andere Lasten angewendet werden.

Vorzugsweise werden die Modellparameter im laufenden Betriebe laufend mitgeschätzt (bspw. mit Recursive Least Squares (RLS)), wenn sich die Dynamik der Last während des Betriebs zu stark ändert. Auch der Regler wird dann mit den veränderlichen Parametern zur Laufzeit ständig neu ausgelegt.

**Patentansprüche**

1. Verfahren zur Prüfung von elektrischen Energiespeichersystemen für den Antrieb von Fahrzeugen, bei dem der Laststrom des Energiespeichersystems von einem Batterietester erzeugt wird und mittels eines Regelkreises mit einem Modell des Batterietesters als Regelstrecke einem gemäß vorgegebenen Testzyklen zeitlich veränderlichen Referenzstrom möglichst exakt und ohne Verzugszeit nachgeführt wird, **dadurch gekennzeichnet, dass** der Regelkreis mittels eines modellbasierten Reglerentwurfsverfahrens erstellt wird, bei welchem in das Modell der Regelstrecke ein Modell des Energiespeichersystems als Last eingebunden wird.

2. Verfahren nach Anspruch 1, **dadurch gekennzeichnet, dass** das elektrische Energiespeichersystem als Last mit dem Batterietester verbunden wird und dem elektrischen Energiespeichersystem mittels einem vorläufigen Regler ohne Lastmodell durch den Batterietester eine Anregungssequenz aufgeschaltet wird und dabei Messdaten am elektrischen Energiespeichersystem erfasst werden, wobei aus den Messdaten mit einer Identifikationsmethode ein Lastmodell identifiziert wird und in das Modell des Batterietesters das identifizierte Lastmodell eingebunden wird.

3. Verfahren nach Anspruch 1, **dadurch gekennzeichnet, dass** die Parameter für ein generisches Modell der Batterieimpedanz durch zumindest eine kurze Anregungssequenz und Messung der resultierenden Werte von Strom und Spannung identifiziert werden.

4. Vorrichtung zur Prüfung von elektrischen Energiespeichersystemen für den Antrieb von Fahrzeugen, mit einem Batterietester zur Erzeugung eines Laststromes des Energiespeichersystems und mit einem Regelkreis mit einem Modell des Batterietesters als Regelstrecke zur Nachführung des Laststromes des Energiespeichersystems gemäß vorgegebenen Testzyklen nach einem zeitlich veränderlichen Referenzstrom möglichst exakt und ohne Verzugszeit, **dadurch gekennzeichnet, dass** im Regelkreis eine modellbasierte Regelung realisiert und in dessen Modell der Regelstrecke ein Modell des Energiespeichersystems als Last eingebunden ist.

5. Vorrichtung nach Anspruch 4, **dadurch gekennzeichnet, dass** ein vom Arbeitspunkt der Batterie abhängiges Modell der Batterieimpedanz eingebunden ist.

**6.** Vorrichtung nach Anspruch 4, **dadurch gekennzeichnet, dass** ein vom Ladezustand der Batterie abhängiges Modell der Batterieimpedanz eingebunden ist.

**7.** Vorrichtung nach Anspruch 4, **dadurch gekennzeichnet, dass** ein vom alter der Batterie abhängiges Modell der Batterieimpedanz eingebunden ist.

**8.** Vorrichtung nach einem der Ansprüche 4 bis 7, **dadurch gekennzeichnet, dass** im Regelkreis eine modellbasierte prädiktive Regelung realisiert ist.

**9.** Vorrichtung nach einem der Ansprüche 4 bis 8, **dadurch gekennzeichnet, dass** das Modell der Batterieimpedanz als Übertragungsfunktion 2. oder höherer Ordnung dargestellt ist.

**Claims**

**1.** A method for testing electrical energy storage systems for driving vehicles, in which method the load current of the energy storage system is generated by a battery tester and traces a reference current that varies over time according to predetermined test cycles as exact as possible and without delay by means of a control loop with a model of the battery tester as the controlled system, **characterized in that** the control loop is created by means of a model-based controller design method, in which a model of the energy storage system as the load is integrated in the model of the controlled system.

**2.** The method according to claim 1, **characterized in that** the electrical energy storage system as the load is connected to the battery tester, and an excitation sequence is applied to the electrical energy storage system by the battery tester by means of a preliminary controller without load model, and in the process of this, measurement data is acquired at the electrical energy storage system, wherein from said measurement data a load model is identified by means of an identification method, and the identified load model is integrated into the model of the battery tester.

**3.** The method according to claim 1, **characterized in that** the parameters for a generic model of the battery impedance are identified by at least one short excitation sequence and measurement of the resulting values of current and voltage.

**4.** A device for testing electrical energy storage systems for driving vehicles, comprising a battery tester for generating a load current of the energy storage system, and comprising a control loop with a model of the battery tester as the controlled system for tracing a reference current that varies over time according to predetermined test cycles with the load current of the energy storage system to trace as exact as possible and without delay, **characterized in that** a model-based control is implemented in the control loop and in its model a model of the of the energy storage system as the load is integrated.

**5.** The device according to claim 4, **characterized in that** a model of the battery impedance is integrated, which model depends on the operating point of the battery.

**6.** The device according to claim 4, **characterized in that** a model of the battery impedance is integrated, which model depends on the state of charge of the battery.

**7.** The device according to claim 4, **characterized in that** a model of the battery impedance is integrated, which model depends on the age of the battery.

**8.** The device according to any one of claims 4 to 7, **characterized in that** a model-based predictive control is implemented in the control loop.

**9.** The device according to any one of claims 4 to 8, **characterized in that** the model of the battery impedance is represented as a transfer function of second or higher order.

**Revendications**

**1.** Procédé de contrôle de systèmes d'accumulation d'énergie électrique pour l'entraînement de véhicules, dans lequel le courant de charge du système d'accumulation d'énergie est généré par un testeur de batterie et est asservi de manière aussi précise que possible et sans retardement à un courant de référence, modifiable temporellement suivant des cycles de tests prédéfinis, au moyen d'un circuit de régulation pourvu d'un modèle du testeur de batterie sous forme d'un système asservi, **caractérisé en ce que** le circuit de régulation est réalisé au moyen d'un procédé de projet de régulation, basé sur un modèle, dans lequel un modèle du système d'accumulation d'énergie est intégré en tant que charge dans le modèle de système de régulation.

2. Procédé selon la revendication 1, **caractérisé en ce que** le système d'accumulation d'énergie est raccordé en tant que charge au testeur de batterie et une séquence d'excitation est appliquée au système d'accumulation d'énergie électrique au moyen d'un régulateur préliminaire sans modèle de charge par le testeur de batterie et **en ce que** des données de mesure sont alors enregistrées au niveau du système d'accumulation d'énergie électrique, un modèle de charge étant identifié à partir des données de mesure par une méthode d'identification et le modèle de charge identifié étant intégré dans le modèle du testeur de batterie.

3. Procédé selon la revendication 1, **caractérisé en ce que** les paramètres destiné à un modèle générique d'impédance de batterie sont identifiés par au moins une brève séquence d'excitation et une mesure des valeurs résultantes de courant et de tension.

4. Dispositif de contrôle de systèmes d'accumulation d'énergie électrique pour l'entraînement de véhicules, comportant un testeur de batterie destiné à générer un courant de charge du système d'accumulation d'énergie et un circuit de régulation pourvu d'un modèle du testeur de batterie sous forme de système asservi pour asservir le courant de charge du système d'accumulation d'énergie, suivant des cycles de tests prédéfinis, à un courant de référence modifiable temporellement de manière aussi précise que possible et sans retardement, **caractérisé en ce qu'**une régulation basée sur un modèle est réalisée dans le circuit de régulation et **en ce qu'**un modèle de système d'accumulation d'énergie est intégré en tant que charge dans le modèle de système asservi dudit circuit de régulation.

5. Dispositif selon la revendication 4, **caractérisé en ce qu'**un modèle de l'impédance de la batterie, dépendant du point de fonctionnement de la batterie, est intégré.

6. Dispositif selon la revendication 4, **caractérisé en ce qu'**un modèle de l'impédance de la batterie, dépendant de l'état de charge de la batterie, est intégré.

7. Dispositif selon la revendication 4, **caractérisé en ce qu'**un modèle de l'impédance de la batterie, dépendant de l'âge de la batterie, est intégré.

8. Dispositif selon une des revendications 4 à 7, **caractérisé en ce qu'**une régulation prédictive, basée sur un modèle, est réalisée dans le circuit de régulation.

9. Dispositif selon une des revendications 4 à 8, **caractérisé en ce que** le modèle d'impédance de la batterie est représenté sous forme d'une fonction de transfert de 2 ordre ou d'ordre supérieur.

Fig. 1

Fig. 2

Modell der Regelstrecke

d
(Stellgröße)

Batterietester

i$_2$
(Regelgröße)

v$_2$
(Störgröße)

## Fig. 3

Modell der Regelstrecke

i$_2$
(Regelgröße)

d
(Stellgröße)

Batterietester

UUT
(Batterie)

v$_2$

$\overline{v}_2$
Störgröße: Modellfehler, Messfehler

## Fig. 4

Fig. 5

Systemantwort auf Anregesequenz

Fig. 6

Simulierte Systemantwort mit initialen Parametern

Zeit [ms]

Fig. 7

Simulierte Systemantwort mit optimierten Parametern

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6577107 B2
- US 2006284617 A1